(19) **Europäisches Patentamt**
**European Patent Office**
**Office européen des brevets**

(11) **EP 4 647 716 A1**

# (12) EUROPEAN PATENT APPLICATION

(43) Date of publication:
**12.11.2025 Bulletin 2025/46**

(21) Application number: **25174403.3**

(22) Date of filing: **06.05.2025**

(51) International Patent Classification (IPC):
**G01B 11/245** (2006.01)   **G01B 11/25** (2006.01)
**G01B 11/30** (2006.01)

(52) Cooperative Patent Classification (CPC):
**G01B 11/245; G01B 11/25; G01B 11/303;**
**G01N 21/952**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **10.05.2024   NO 20240459**

(71) Applicant: **Nexans**
**92400 Courbevoie (FR)**

(72) Inventors:
• **Doedens, Espen**
**N-1788 Halden (NO)**
• **Eyssautier, Quentin**
**N-1734 Hafslundsøy (NO)**

(74) Representative: **Acapo Onsagers AS**
**P.O. Box 1813 Vika**
**0123 Oslo (NO)**

## (54) SURFACE ANALYSIS OF CABLE LAYER

(57)     A system for surface analysis of a cable layer. The system comprises an in-line surface scanner arrangement and a controller. The in-line surface scanner arrangement is for scanning a cable layer in or received from a cable manufacturing line, the scanner arrangement comprising one or more non-contact distance scanners arranged to measure distance to an outer surface of the received cable layer. The controller is arranged to receive scan data of the outer surface of the received cable layer based on signals received from the in-line surface scanner arrangement; extract surface texture data from the scan data; determine one or more properties of the surface of the cable layer based on the surface texture data; compare at least one determined property with one or more threshold criteria; and identify at least one of a surface feature of interest, a deviation, or a defect based on the comparison.

Figure 2

**Description**

**Field of the invention**

The present invention relates to a system for in-line surface analysis of a cable layer, such as a layer of a high-voltage cable. The present invention also relates to a computer implemented method for surface analysis.

**Background**

Electrical cables or wires typically comprise many layers. This is particularly true of high voltage (HV) cables suitable for electric power transmission at high voltage, e.g. above 1 000 V. Each layer serves specific functions to ensure the cable's performance, durability and safety. As an example, a cable may comprise a conductive core which may comprise a plurality of individual conductive strands or wires. The conductor core may be surrounded by an insulating system. In some examples, the insulating system comprises multiple layers. For example, the insulating system may comprise a first or inner semi-conductive layer, then an insulating layer, and then a second or outer semi-conductive layer. In some examples, such as in sub-sea power cables, the cable may further comprise a water barrier layer and, optionally, an armouring layer also. In some examples, the cable may comprise a plurality, optionally three, separate conductive cores. This may be the case of AC cables. In some examples, the cable may comprise further layers such as a metallic shield layer or an outer sheath layer. In some examples, the cable may comprise further features such as fibre optic elements.

The manufacture of an electric cable or wire typically comprises manufacturing the cable layer-by-layer. Different techniques and manufacturing lines may be used to manufacture different layers. Throughout the manufacturing process, strict quality control (QC) measures should be implemented to ensure the uniformity, integrity, and performance of each layer. This includes monitoring parameters such as thickness, ovality, concentricity, adhesion, and electrical properties to meet the required standards and specifications for high voltage power cables. One such QC method is a diameter measurement in which diameter of a cable layer is measured in-line (i.e. a scanning device is provided in or downstream of the manufacturing device and continuously measures cable layer diameter). The respective manufacturing line can be controlled in response to diameter measurements, for example to maintain the diameter within an acceptable range. Examples of a diameter measurement system include the LASER Series 2000 and the LASER Series 6000 systems (available from Sikora AG of Bruchweide 2, D-28307, Bremendiameter) which measure diameter based on a diffraction principal.

There is a need for improved QC measures. In particular, there is a need for a QC approach for analysing fine or textural features of the cable layer and / or the cable layer in cross-section (or, at least, around the full perimeter of the cable layer) in-line.

The fine or textural features may, in some examples, be very small geometric deviations or defects in the layer of features of the layer. These fine deviations or defects can affect the electrical or mechanical performance of a product. For stranded layers (such as conductor layers, copper wire screen layers, armour layers etc.) minute geometric deviations or defects may occur due to wire drawing deviations, or filling in between layers, or incorrect tension, for example. For extruded layers (such as insulation or sheaths) minute geometric deviations or defects may occur due to shrinkage, or surface defects, or drooping, for example. Each of these deviations or defects can affect electric or mechanical performance. Furthermore, minute geometric defects or deviations in individual layers can build up layer by layer. Said geometric deviations are not easily identified using a diameter measurement QC approach, as described above. Thus, there is a need for an in-line QC measure for identifying and / or quantifying these very small geometric deviations or defects.

The fine or textural features may, in some examples, be features of the manufacturing process for the respective cable layer. For example, if a particular manufacturing line comprises a step of welding as part of fabricating a cable layer, then the fine or textural feature formed as part of that manufacturing process may be a weld or weld line. The weld line may be an artefact of extrusion of a plastic layer or, a longitudinal weld of a cable sheath when metallic layers are joined. Again, there is a need for an in-line QC measure to identify the weld line and / or monitor the quality of that weld.

The present invention attempts to address at least some of these points.

**SUMMARY OF THE INVENTION**

The present invention is defined by the appended claims and in the following.

In a first aspect, the invention relates to a system for surface analysis of a cable layer. The system comprises an in-line surface scanner arrangement for receiving a cable layer from a cable manufacturing line. In some embodiments, the in-line surface scanner arrangement is arranged to receive the cable layer directly and continuously. In some embodiments, the respective cable manufacturing line (that the cable layer is received from) is for fabricating said cable layer.

The scanner arrangement comprises one or more non-contact distance scanners arranged to measure distance to an outer surface of the received cable layer. Therefore, the scanner arrangement may provide scan data.

The system comprises a controller. The controller is arranged to receive the scan data of the outer surface of the received cable layer based on signals received from the in-line surface scanner arrangement. The controller is arranged to extract surface texture data from the scan data.

The controller is arranged to determine one or more properties of the surface of the cable layer based on the surface texture data. In some embodiments, the controller is arranged to determine or identify at least one surface feature of interest, a deviation, or a defect in the cable layer. This may be based on a comparison of the at least one property with one or more threshold criteria. The threshold criteria may be referred to as acceptance criteria herein.

As used herein, the "surface texture data" may refer to any data associated with surface texture of the cable layer. This may mean that other features, such as the macro-geometric shape of the cable layer, and, optionally, ovality or off-centring, have been filtered from the scan data.

Extracting surface texture data from the scan data may comprise segmenting the scan data. This may comprise removing the contribution of macro-geometric features in the scan data thus leaving the surface texture data. The inventors have recognized that processing the scan data (as described above) to extract surface texture data to remove the macro-geometric shape or features to leave the surface texture data advantageously enables the textural features of the surface to be analysed by the controller in real-time. Thus, minute geometric deviations or defects in the surface (that form the texture of the surface) can be extracted analysed. This allows for a deeper understanding of the texture of surface of the cable layer than could be achieved with known QC approaches. The step of extracting the surface texture data could be described as segmenting the scan data. The segmented approach may advantageously be tailored to a unique product such that both the dimensions and textures that characterize it and defects/deviation are assessed. For example, the segmented quality approach may provide information such as: where on the cable ovality did a defect occur, or where on the pitched wire layer did this defect occur. Another example could be determining how close a defect is it to a longitudinal weld.

As used herein, the surface scanner being "in-line" means that the surface scanner is arranged to scan the surface of the cable layer continuously, as the respective cable layer is fabricated. In some example, in-line means immediately after, or in, the manufacturing process making or fabricating the cable layer. In some examples, an in-line scanner arrangement may be where the cable is manufactured to a drum or turntable and thereafter spooled through the device, still in a cable line, but not right after the process. An in-line scanner arrangement must generally be able to operate at full line speed. An advantage of providing the scanner arrangement in-line is that the quality feedback loop may introduced for example, to control the manufacturing line in response to the surface analysis in real time.

As used herein, the "macro-geometric shape or features" of the cable layer may refer to aspects such as its size, proportions, orientation, and general form. These features describe the shape of the cable layer in a broad sense, without delving into intricate details or finer elements.

As used herein, the "minute features" may refer to surface variations of less than 1000 micrometres, optionally of less than 500 micrometres.

As used herein, a "feature of interest" or a "surface feature of interest" may refer to any feature of the surface of the cable that is of interest. This could include weld lines, individual strands of a stranded cable layer, gaps between strands of stranded cable layers, individual strands of tape in tape wrapped layers etc. Identifying a feature as a feature of interest may comprise comparing the at least one property to a threshold criteria that has been selected to distinguish that particular type of feature. For example, a longitudinal weld line may be detected based on an area of increased height having a particular width on the surface of the cable layer. The feature of interest may be any surface texture feature.

As used herein, the "surface texture feature" may be any feature in the surface of the cable layer. The surface texture features may be derived from the surface texture data. The surface feature may vary from cable layer to cable layer. Surface texture features include ridges or troughs resulting from localised geometric defects in the cable layer and / or from underlying non-continuous layers such as stranded layers in which individual strands and gaps between strands may cause a waviness to subsequent cable layers. For stranded cable layers, surface texture features could be individual strands or gaps between strands. For cable layers comprising a wrap, such as a tape wrap, surface texture features could include individual wrapping or tapes. Surface texture features could include weld lines. Weld lines could be longitudinal (i.e. parallel to the length of the cable layer) or transverse (i.e. wrap circumferentially around the cable layer).

As used herein, "deviations" and "defects" may both refer to when one or more properties of the surface of the cable layer fall outside a threshold criterion. A deviation may refer to the property being outside of an ideal range, but that is still acceptable. A defect may refer to the property being such that it is indicative of a fault with the manufacturing process. For example, the property might be pitch. It may be acceptable for pitch to vary by up to +/- 5% from an idealised value, but it may be advantageous to quantify that deviation. For example, to quantify and monitor the pitch if it varies by more than +/- 1% from the idealised value. Variation by more than +/- 1% but less than +/- 5% could be described as a deviation in on example. A defect might be determined if the pitch is greater than +/- 5% of the idealised value. These percentages are merely illustrative.

The cable layer may be any layer of a cable. The cable layer may be the outermost layer of a partially manufactured cable. As above, a cable may typically be manufactured layer-by-layer using various manufacturing lines. Thus, the cable layer being scanned may be the most recently manufactured or fabricated layer of the cable. The cable layer could also be called an "intermediate" layer of the cable.

In some embodiments, the scan data is a three-dimensional surface geometry measure of the surface of the cable layer. The system may comprise a non-transitory memory. The system, e.g. the controller, may be arranged to transmit scan data to the non-transitory as a 3D topographic map of the surface of the cable layer.

The in-line surface scanner may be described as a 3D surface scanner. A 3D surface scanner may be understood as a device that is configured to capture the shape of a three-dimensional object. This may be done by measuring the distances between the 3D surface scanner and various points on the object's surface when moving the 3D surface scanner about the object. The 3D surface scanner may use sensors and a light source, such as a laser, to project a pattern onto the object and record the reflected or displaced light. The 3D scanner may then calculate the 3D coordinates of each point using triangulation or other methods, and may form a point cloud of the scanned object. Thus, the scan data may be point cloud data of the cable layer. By scanning a cable layer in-line with such a 3D surface scanner, the surface of the cable layer, as well as the volume enclosed by the layer, can be determined.

The scan data may comprise co-ordinate data for each point in the point cloud. For example, the scan data may comprise an array or matrix of coordinate datapoints. In some embodiments, the scan data may be defined by a cartesian coordinate system. In such embodiments, the scan data may comprise x, y and z information for the, a plurality of, or each point in the point cloud. In some embodiments, the scan data may be defined by a polar coordinate system such as a cylindrical polar coordinate system. The cylindrical coordinate system may comprise a longitudinal axis. Distance along the longitudinal axis may be defined by "z". The longitudinal axis may extend substantially parallel to a longitudinal axis of the cable layer. In some examples, the scanner arrangement may receive the cable in a direction that is substantially parallel to the longitudinal axis of the cable layer and / or the cylindrical coordinate system.

As used herein, the at least one "property" of the outer surface determined by the controller may be any property that can be determined from the scan data. For example, the at least one property could be a pitch associated with the cable layer. If the cable layer comprises a plurality of individual strands, the at least one property could be a property of individual wire strands such as width or diameter or a property of gaps between strands. If the cable layer comprises a weld line, the at least one property could be a property of a weld line such as a height. In some examples, the cable layer comprises a spirally wrapped material such as a spirally wrapped tape, metal or polymer strip, or laminate. In such examples, the at least one property could be pitch of the spirally wrapped material or an overlap or gap between adjacent windings of the wrapped material. If the cable layer comprises a fibre optic (FI) or fibre in metal tube (FIMT), or a slot for said FI or FIMT, then the at least one property may be a property indicative of the positioning of the FI or FIMT with respect to said slot. If the cable layer comprises a corrugated sheath, the at one property may relates to the regularity of a pattern, such as a waved pattern, in the corrugated sheath. The controller may be arranged to determine or plot the or each property against length for the cable layer.

As used herein, the "threshold criteria" may be any criteria that is suitable for distinguishing or identifying: a (surface texture) feature as being feature of interest, a deviation, or a defect.

As used herein, "pitch" may refer to a property of helically coiled features. For example, the helically coiled feature may be a helically coiled conductor strand or a helically coiled tape wrap. The pitch may refer to an angle between a local portion of the helical coil and the cable layers centre axis (or a central axis of the helical coil shape).

As used herein, a "lay length" may refer to the axial distance required for the cable layer to complete one revolution around a longitudinal axis thereof.

Pitch and lay length are important parameters in determining the overall twist rate and geometry of the cable, which can influence its flexibility, strength, and other mechanical properties. In particular, controlling pitch and / or lay length is important for controlling the torsional stability of the manufactured cable.

In some embodiments, extracting the surface texture data from the scan data comprises subtracting a reference surface or a primary surface from the scan data.

In some embodiments, the reference surface or primary surface is representative of a macro-structure (e.g macro-geometric shape) of the cable layer. In other words, the reference surface or primary surface (which is representative of the macro-geometric shape of the cable layer) is a surface which reflects or is representative of the overall surface topology of the cable layer excluding surface texture. For example, if a cable layer is known or assumed to be substantially cylindrical, the primary surface may be a perfectly cylindrical surface having a first radius equal to the assumed radius of the cylindrical cable layer. In reality, the cable layer may have surface texture such that one or more portions of the surface of the cable layer deviate from the first radius. This may be due to manufacturing tolerances, for example. However, this texture will not be present in the perfectly cylindrical primary surface. Thus, the primary surface may be representative of the macro-geometric shape of the cable layer but may not comprise surface texture. By subtracting the primary surface from the scan data, the macro-structural features of the cable layer may be removed from the scan data. This may leave smaller-scale, textural features remaining in the scan data. Thus, the extracting may extract data representative of textural surface features (i.e. surface texture data may be extracted). The reference surface or primary surface may be described as being an idealised reference surface. This may be because the reference surface is absent of surface texture.

In some embodiments, the controller may be arranged to receive or determine a reference point cloud. The reference point cloud may be a point cloud that defines the primary surface or reference surface. Each point of the reference point cloud may be associated with a point of the point cloud of the scan data. In other words, there may be substantially the same number of points in the point cloud of the scan data as in the reference point cloud. The resolution of the point cloud of the scan data may be substantially the same as the resolution of the reference point cloud. In such embodiments, extracting surface texture data from the scan data may comprise the controller being arranged to, for each point of point cloud of the scan data, subtracting a respective point of the reference point cloud. This may also be generally described as subtracting the primary surface from the scan data.

In some embodiments, the controller is arranged to receive or determine the primary surface. There are several different ways in which the primary surface (representative of the macro-geometric shape of the cable layer) can be received or determined.

In some embodiments, the controller may be arranged to receive or determine the primary surface by fitting a surface to at least some of the scan data using a surface fitting algorithm. The surface fitting algorithm may be arranged to determine a surface of best fit for the scan data. The surface fitting algorithm may filter out surface textural features from the primary surface relative to the actual scanned data. Thus, subtracting the primary surface from the scan data may extract the surface texture data.

In some embodiments, the controller may be arranged to receive or determine the primary surface by a) receiving scan data during a sampling window for a first length of the cable layer, b) determining an average for the measured distance to the surface around the cable layer for the first length of cable, and c) forming the primary surface based on the average measured distance. The averaging may filter out or smooth out surface textural features from the primary surface relative to the actual scanned data. Thus, subtracting the primary surface from the scan data may extract the surface texture data.

In some embodiments, receive a predetermined (three-dimensional) model of the cable layer comprising the primary surface. The predetermined model may not include at least some surface textural features. Thus, subtracting the primary surface from the scan data may extract the surface texture data.

In some embodiments, the system comprises a non-transitory memory. The controller may be arranged to store scan data associated with a determined feature of interest, a deviation or a defect in response to detection thereof. The controller may be arranged to not store scan data otherwise. In other words, the controller may be arranged to only store scan data associated with determined features of interest, deviations and defects. This may advantageously reduce the memory requirements for storing scan data.

In some embodiments, the system comprises a digital twin monitoring unit. The digital twin monitoring unit is arranged to perform digital twin modelling of the cable layer based on at least some of the scan data or surface texture data to create a representation of the cable or cable layer. The digital twin monitoring unit is arranged such that the representation comprises scan data and / or surface texture data associated with determined deviations or defects when said determined deviations or defects or determined. In some embodiments, the representation includes positional information of the feature of interest, deviation, or defect. In some embodiments, the positional information comprises the position of the deviation or defect along a length of the cable layer and / or around the circumference of the cable layer.

A digital twin is a digital representation of an intended or actual real-world physical product, system, or process that serves as the effectively indistinguishable digital counterpart of it for practical purposes, such as simulation, integration, testing, monitoring, and maintenance. The digital twin has been intended from its initial introduction to be the underlying premise for Product Lifecycle Management and exists throughout the entire lifecycle, create, build, operate/support, and dispose, of the physical entity it represents. The digital twin can and does often exist before there is a physical entity.

Once informed with such data, the virtual model can be used to run simulations, study performance issues and generate possible improvements, all with the goal of generating valuable insights - which can then be applied back to the original physical object. The digital twin also serves as a useful record of the cable layer into the future. The cable layer may exist in use in a cable product for at least 40 years. Maintenance may need to be carried on the cable layer at regular or irregular intervals. During such maintenance, the digital twin can serve as a record of the location and presence of deviations in any or each cable layer at the location where the maintenance is being carried out.

In some embodiments, the system may comprise one or more indicators. The one or more indicators could be one or more visual or audible indictors, for example. The controller may be arranged to control said one or more indicators to transmit an alert signal if a defect is detected. This may prompt an operator of the manufacturing line to check the parameter of the manufacturing line. In some embodiments, the controller may be arranged to stop the respective manufacturing line if a defect is detected.

In some embodiments, one or more of the threshold or acceptance criteria are spatially dependent.

In some embodiments, the controller is arranged to record a relationship between the or each property of the outer surface of the cable layer and a longitudinal length of the cable layer.

In some embodiments, the scanner arrangement is arranged such that the cable layer is receivable and guidable therethrough in a lengthwise manner. This may be such that a feed direction of the received cable layer is substantially parallel to a longitudinal axis of the cable layer.

In some embodiments, the one or more non-contact distance scanners are arranged such that a scanning area extends substantially around a circumference of the received cable layer. In some embodiments, the system is arranged such that the cable layer is moveable with respect to the one or more non-contact distance scanners (e.g. in a longitudinal direction). Thus, the scanning area may move over the outer surface of the cable layer as the cable layer moves therethrough. In this way, the in-line scanner arrangement may be suitable for continuously scanning the cable layer as it is moves through the respective manufacturing line.

The cable layer may be the outermost layer of a partially manufactured cable.

In some embodiments, the cable layer is one of a conductor layer e.g. a conductor stranding, wire screen layer, an insulation layer, an armouring layer, an extruded sheath layer, a water barrier layer.

In some embodiments, the controller is arranged to determine an ovality of the cable layer and / or an off-centring of the cable layer with respect to the surface scanner arrangement. In such embodiments, the controller may be arranged to process the scan data to compensate for said ovality and / or off-centring. This may be before subtracting the primary surface from the scan data. In this way, off-centring or ovality is advantageously removed from the scan data.

In some embodiments, the system further comprises a cable manufacturing line for fabricating the cable layer. The cable manufacturing line may be a conductor stranding line, a tape lapping line, a metal screen welding line, a cabling line, an armouring line, a lay-up line, a screening line, a wire drawing line or a core extrusion line.

In some embodiments, the controller is arranged to control the respective manufacturing line. If the controller determines a defect in the cables, the controller may be arranged to adjust a parameter of the manufacturing line in response to the detected defect. For example, if the at least one property is pitch, the controller may be arranged to adjust a rotation speed of bobbins. This may be with a PID controller in order to have a fixed pitch regardless of line speed.

In some embodiments, the cable layer is a layer of a high-voltage and / or sub-sea cable. In some embodiments, the cable layer is a layer of an cable suitable for power transmission, e.g. AC or DC power transmission.

In a second aspect, there is provided a system for surface analysis of a cable layer. The system comprises: an in-line surface scanner arrangement for scanning a cable layer in or received from a cable manufacturing line. The scanner arrangement comprises one or more non-contact distance scanners arranged to measure distance to an outer surface of the received cable layer. The system further comprises a controller. The controller is arranged to receive scan data of the outer surface of the received cable layer based on signals received from the in-line surface scanner arrangement. The controller is arranged to fit a surface to at least some of the scan data using a surface fitting algorithm. The controller is arranged to extract surface texture data from the scan data. The extracting comprising subtracting the fitted surface. The controller is further arranged to determine one or more properties of the surface of the cable layer based on the surface texture data. The controller is arranged to compare at least one determined property with one or more threshold criteria. The controller is arranged to identify at least one of a surface feature of interest, a deviation, or a defect based on the comparison.

In a third aspect, there is provided a computer-implemented method of surface analysis of a cable layer, the method comprising the steps of:

receiving scan data from an in-line surface scanner arrangement comprising one or more non-contact distance scanners for measuring an outer surface of the cable layer, wherein the cable layer has been fabricated by a cable manufacturing line;

extracting surface texture data from the scan data;

determining one or more properties of the surface of the cable layer based on the surface texture data;

comparing at least one determined property with one or more threshold criteria; and

identifying at least one of a surface feature of interest, a deviation, or a defect based on the comparison.

In a fourth aspect, there is provided a computer program product comprising instructions which, when the program is executed by a computer, cause the computer to carry out the steps of the method of the third aspect.

In a fifth aspect, there is provided a computer-readable storage medium comprising instructions which, when executed by a computer, cause the computer to carry out the steps of the method of the third aspect.

It should be understood that features and advantages described in relation to the system of the first aspect are also applicable to the system of the second aspect and the method of the third aspect.

**Short description of the drawings**

In the following description this invention will be further explained by way of exemplary embodiments shown in the drawings, in which:

Figure 1A illustrates a cross-sectional view of a portion of a high-voltage cable;

Figure 1B illustrates a perspective view of a portion of the high-voltage cable of Figure 1A;

Figure 2 schematically illustrates a manufacturing line comprising an in-line surface scanner arrangement;

Figure 3 schematically illustrates features of the in-line surface scanner arrangement of Figure 2;

Figure 4 schematically illustrates a data processing unit of the system;

Figure 5 is a flow diagram for a method according to the present disclosure;

Figure 6 is a schematic view of a helically stranded cable layer comprising tape;

Figure 7 is 2-D representation of the scan data derived from scanning the surface of the stranded cable core of Figure 6;

Figure 8 is 2-D topological map of the surface texture of stranded cable core of Figure 6;

Figure 9 illustrates an example of a cable layer in which the helical windings are non-uniform;

Figure 10 illustrates a second example of a cable layer that is different to the cable layer of the first example, and comprises a weld line;

Figure 11 is a 2-D representation of the surface features of the cable layer;

Figure 12 is a 2-D representation of the surface features of a portion of a third example of a cable layer;

Figure 13 illustrates an example of a digital twin;

Figure 14 illustrates a scan that is off-centered; and

Figure 15 illustrates a scan that has non-zero ovality.

**Detailed description of the invention**

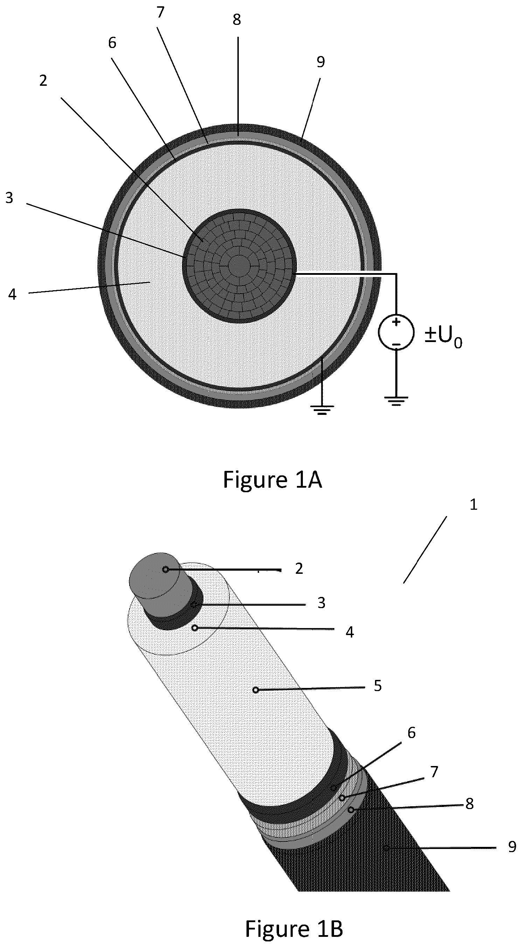

Figure 1A and B illustrate a detailed view of a portion of a high voltage cable 1. Figure 1A illustrates a cross-section of the high voltage cable 1. Figure 1B illustrates a perspective view of the high voltage cable 1 in which the different layers of the cable have been stripped away sequentially for illustrative purposes. The high voltage cable 1 comprises an outer sheath 9, a lead sheath 8, swelling tapes 7 and an outer semiconducting screen 6. The high voltage cable 1 further comprises an insulation layer 4 having surface 5, an inner semiconducting screen 3 and conductor 2.

During manufacture of high voltage cable 1, the cable 1 may be fabricated layer-by-layer. For example, a wire drawing line may be used to initially draw conductive wires. A stranding line may receive drawn wire to form a conductor core. As the skilled reader will appreciate, there may be any number of manufacturing lines involved in the manufacture or fabrication of different layers of the cable 1. As examples, these could include (in addition to the wire drawing line and stranding line): a tape lapping line or tape lapping head within the other lines, a metal screen extrusion or welding line, a cabling line, an armouring line, a lay-up line, a screening line, and an a core extrusion line. The present invention provides a means for in-line scanning and quality control of individual cable layers. In-line here means that the scanning is performed continuously as the respective layer is fabricated by the respective manufacturing line.

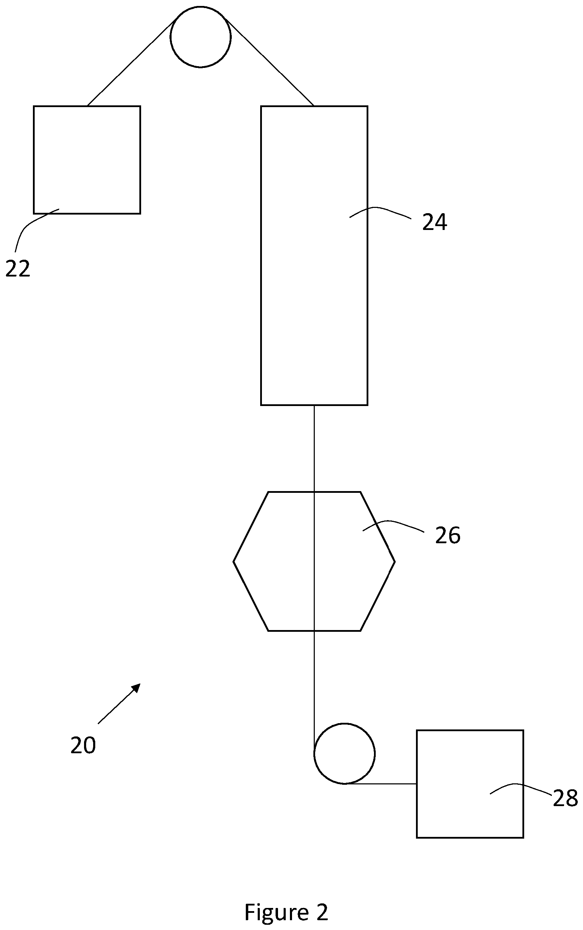

Figure 2 shows a schematic view of a manufacturing line 20 comprising a scanner arrangement according to the present invention. The manufacturing line comprises a payoff 22 or other material supply, a wire stranding arrangement 24, a scanner arrangement 26, and a take up 28. The scanner arrangement 26 is installed between the payoff 22 and the take up 28. More specifically, in this example, the scanner arrangement 26 is installed between the wire standing arrangement 24 and the take up 28. In this example, a single payoff 22 is shown in Figure 2. However, it should be understood that there may be a plurality of payoffs 22 in some examples. The or each payoff 22 is a spool of extruded wire. The wire stranding arrangement 24 is arranged to receive one or more individual wire strands from the one or more payoffs 22 and arranged to form a stranded core 30. The stranded core 30 is guidable through the scanner arrangement 26 (for scanning the outer surface of the stranded core 30) and then to the take-up 28. The stranded core will be referred to as the cable layer herein.

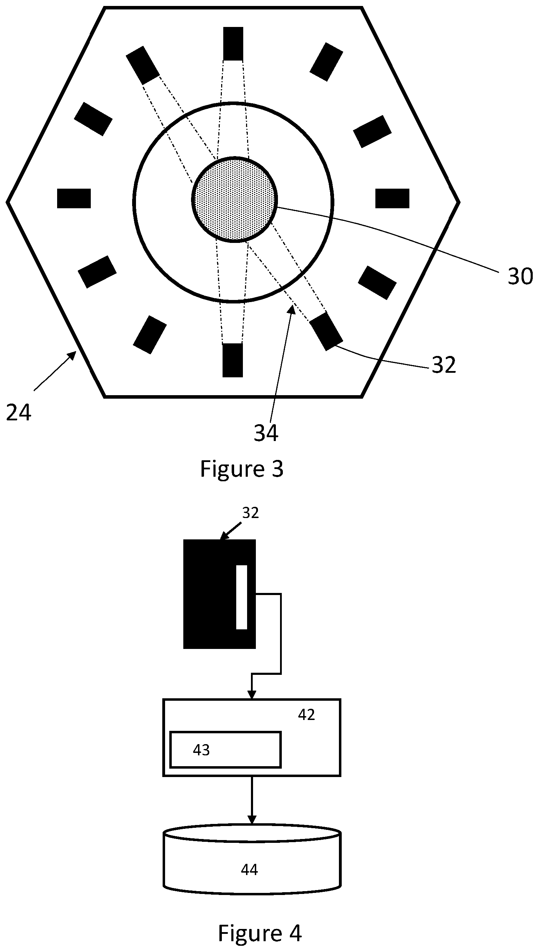

Figure 3 illustrates the scanner arrangement 24. In particular, Figure 3 is a schematic view of a cross-section of the scanner arrangement 24 with a cable layer 30 received therein. The scanner arrangement 24 comprises 12 non-contact distance scanners 32. Each of the non-contact distance scanners 32 comprises a laser and an optical sensor and is arranged to measure distance from the non-contact distance scanner 32 to the surface of the stranded core 30 over an area of interest. Each scanner 32 has a field of view 34, the boundaries of which are represented by the broken lines in Figure 3. The field of view 34 of four of the 12 scanners is represented in Figure 3. In this example, the 12 scanners 32 are distributed substantially equidistantly around the region of the scanner arrangement 24 that receives the cable layer 30. The scanners 12 are arranged such that the field of view 34 of adjacent scanners either partially overlaps or exactly abuts. In this way, collectively, the scanners 12 have a field of view 34 extending completely around the cable layer 30. In this way, the full surface of the cable layer 30 can be scanned as it passes through the scanner arrangement 24. Of course, such a complete field of view can be achieved in other ways. For example, by providing fewer scanners 12 but rotating those scanners 12 about the cable layer 30 as the cable layer 30 is guided therethrough.

Figure 4 schematically illustrates a data processing unit 40 of the system. The data processing unit 40 comprises an analysis part 42. The analysis part 42 is in communication with the non-contact surface scanner 32 over a wired or wireless communication link. The analysis part 42 comprises a processor 43 adapted to process measurement data from the non-contact surface scanner 32 for each of the plurality of sub-areas to create a point cloud of the scanned surface. The processor 43 also receives measurement data from the other 11 non-contact surface scanners 32. In this way, a high-resolution point cloud of the full circumference of the cable layer 30 can be built up continuously as the cable layer 30 passes through the scanner arrangement 24 from the manufacturing line 20.

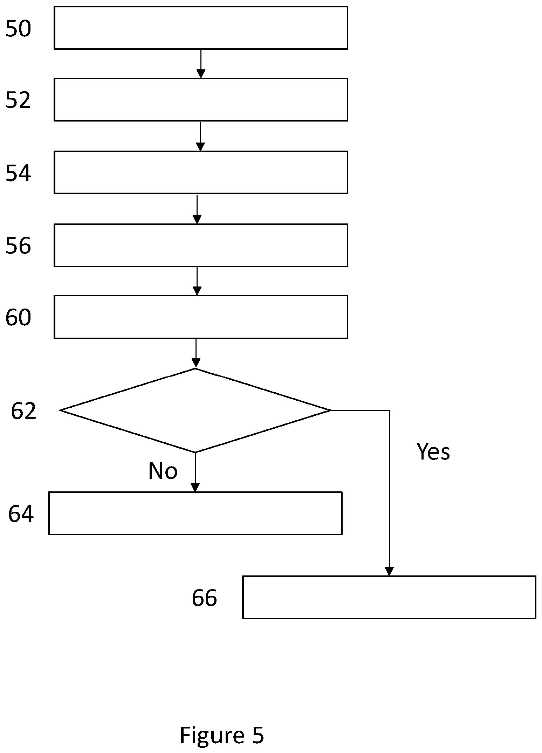

The processor 43 is further arranged to perform surface analysis on the scanned surface of the cable layer 30. This processing is described in more detail in relation to Figure 5 which is a flow diagram representing the steps of a method according to the present disclosure.

Step 50 of the method is to fabricate the cable layer 30 using the manufacturing line 20. Step 50 further comprises the scanner arrangement 24 receiving the cable layer 30.

Step 52 of the method comprises scanning the outer surface of the cable layer 30 using the non-contact surface scanners 32. The processor 43 is arranged to form a point cloud of the scanned surface. Thus, the scanned data may be described as a point cloud. If the datapoints of the point cloud are originally recorded as cartesian coordinates, then the coordinates may conveniently be converted to cylindrical polar coordinates at this stage. Cylindrical polar coordinates may be advantageous because the algorithms can be arranged to assess variance in radius. This is much simpler than if a cartesian coordinate system is used where variance in multiple parameters (x, y and x) may need to be assessed to determine the same surface texture features, for example.

Step 52 of the method comprises the processor 43 being arranged to apply a surface fitting algorithm to the point cloud of the scanned data. The surface fitting algorithm will smooth out or filter out surface texture in the scanned data. The skilled reader will be familiar with suitable surface fitting algorithms for fitting a surface to point cloud of the scanned data. Such surface fitting algorithms could include a non-linear least square fit for example.

Step 54 of the method comprises the processor 43 converting the fitted surface into a reference point cloud. The reference point cloud, in this example, will have the same resolution as the point cloud of the scanned data. Thus, each point of the reference point cloud may be associated with a point of the point cloud of the scanned data. The reference point cloud uses the same coordinate system as the point cloud of the scanned data. Thus, the reference point cloud may also conveniently be defined by cylindrical polar coordinates.

Step 56 of the method comprises extracting surface texture data from the scanned data. In this example, this is achieved by subtracting the fitted surface of step 52 from the scanned data. In particular, in this example, the extracting comprises subtracting each point of the reference point cloud from the respective point in the scan data point cloud. Because the reference point cloud is based on the fitted surface in which surface texture has been removed, the extraction leaves only the surface texture. In other words, the scan data is segmented to form the surface texture data.

Step 60 of the method comprises determining at least one property of the surface of the cable layer based on the surface texture data.

Step 62 comprises comparing the at least one property to one or more threshold criteria. In this example, the threshold criteria is or are stored in a memory of the system. The processor 43 is arranged to retrieve the threshold criteria from the memory and use it in the comparison. In some examples, a look-up table is stored in the memory. The processor 43 may receive, as input (for example, from a user), properties of the cable layer being scanned. Those properties may then be used to look-up appropriate threshold criteria in the look-up table. In other examples, a user may directly input the threshold criteria to be used.

If one or more threshold criteria are not satisfied then the method moves to step 64 which is to identify a feature of interest, a defect, or a deviation. In this example, step 64 also comprises the analysis part 42 transmitting the scan data associated with the identified feature to a storage device 44 as a 3D topographic map. The analysis part 42 is in communication with the storage device 44 over a wired or wireless communication link. The storage device 44 may be on an on-premises server or cloud server. The 3D topographic map of the surface 5 of the cable 1 on the server 44 may be accessible to users and clients for future reference of the cable system.

If the or each threshold criteria is satisfied, then the method moves to step 66 and does nothing. In particular, scan data may not be sent to the memory. In this way, only information about features of interest may be stored in the memory thus reducing memory requirements.

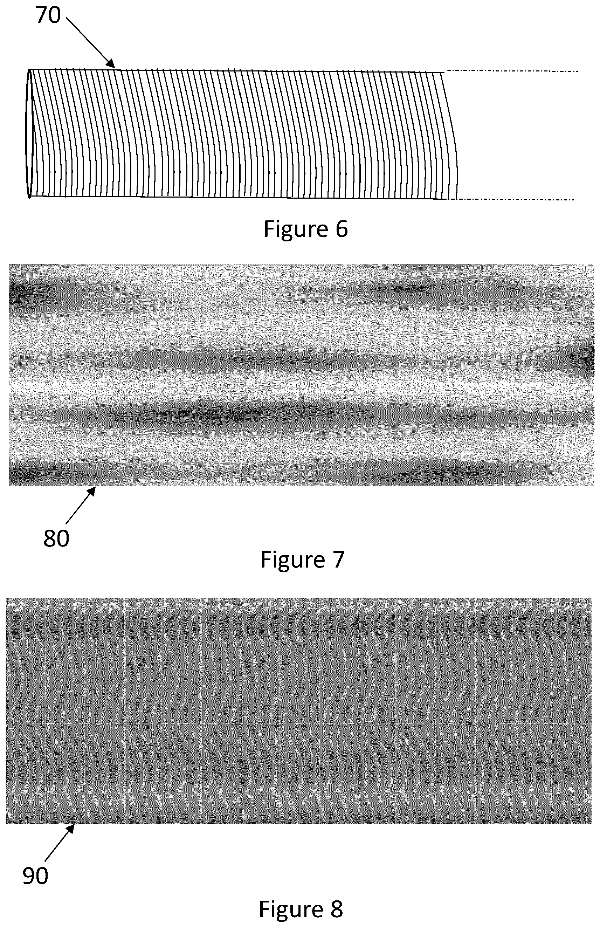

As above, the method can be applied to various cable layers and for determining various features and may be provided in-line to any sort of manufacturing line for manufacturing or fabricating a cable layer. In one example, the cable layer may be a stranded core layer. An example of this is shown in Figure 6 which is a schematic view of a cable layer 70 comprising helically wrapped tape over a stranded conductor.

Figure 7 is 2-D representation 80 of the point cloud / scan data derived from scanning the cable layer 70. The representation in Figure 7 is greyscale with darker regions representing a greater distance from scanner to surface and lighter regions representing a smaller distance from scanner to surface. In other words, Figure 7 is 2-D topological map of the surface of the cable layer 70 as scanned by the scanner arrangement 24.

Figure 8 is a similar 2-D topological map 90 to Figure 7. However, the map of Figure 8 has been extracted from the map of Figure 7 by first applying a surface fitting algorithm to the representation 80 of Figure 7 and then subtracting the fitted surface, as described above. Thus, Figure 8 is 2-D topological map 90 of the surface features or surface texture of the stranded cable core 70. In particular, it should be apparent that the wavey nature of the map 90 of Figure 8 corresponds to a 2D projection of the helical shape of the cable layer 70.

There are a number of different properties that could be determined from the map 90 of Figure 8. For example, the width of the tape forming the helically wrapped tape could be determined. However, in this example, the focus is on pitch. In this example, the angle and so the pitch of the helically coiled strand is substantially uniform. In this example, the threshold criteria is a range of acceptable values for pitch. The pitch of each strand can be deduced from the surface texture map using a fitting algorithm, for example. If the pitch falls within the threshold criteria, then the pitch is acceptable (indicating that the cable layer should have acceptable torsional properties). If the pitch falls outside the threshold criteria, then the pitch is not acceptable and this is indicative of a deviation or defect in the manufacturing process. In this example, the pitch is uniform and falls within the threshold criteria. Thus, the method can move to step 66 and do nothing.

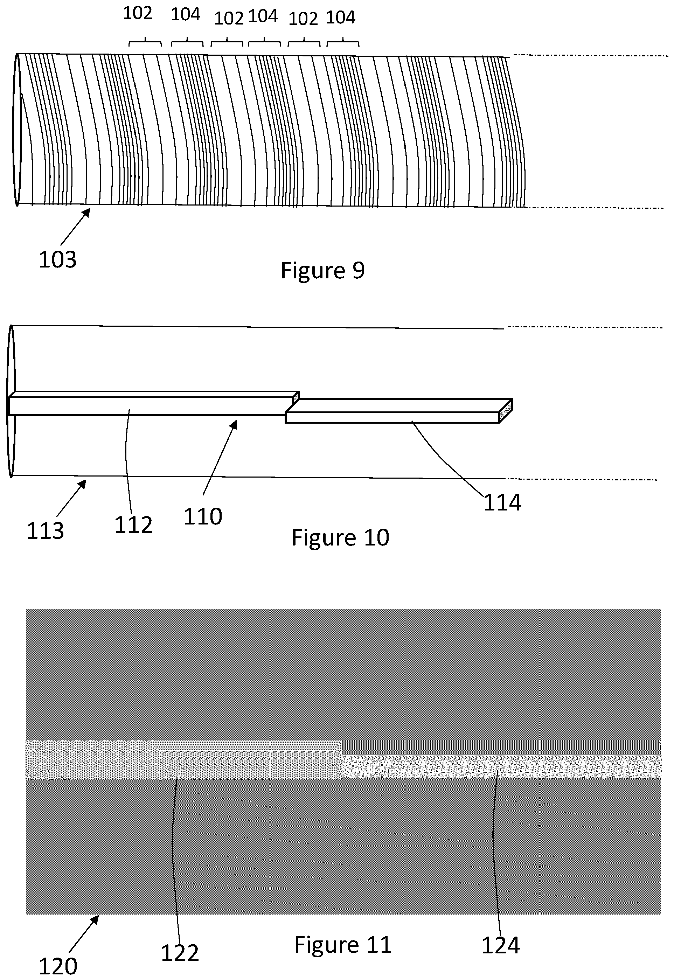

Figure 9 shows an example of a cable layer 103 in which the helical windings are non-uniform. There are a first set of zones 102 of the cable layer 103 in which the pitch or lay length is reduced. There are a second set of zones 104 of the cable layer 103 in which the pitch or lay length is increased. Thus, in this example, the pitch varies from the zone to zone. In this example, the pitch in the first set of zones 102 falls within the threshold criteria but the pitch in the second set of zones 104 falls outside the acceptable range of the threshold criteria. Thus, as the second set of zones 104 of the cable layer 103 passes through the scanner arrangement, the threshold criteria is not met. In this example, this means that a defect or deviation is detected associated with each of the second set of zones 104. The scan data associated with the defect or deviation is recorded in the memory or storage device 44. This can be useful for later reference. For example, during maintenance procedures. Furthermore, in some examples, subsequent manufacturing lines (for manufacturing subsequent layers of the cable) may be adjusted to compensate for the variation in pitch in the cable layer 103.

Furthermore, in some examples, the processor 42 is arranged to control the manufacturing line for manufacturing cable layer 103 in real-time to compensate for variations and changes in pitch. This may be through use of PID control, for example.

Figure 10 shows a second example of a cable layer 113 that is different to the cable layer of the first example. Figure 10 is schematic. The cable layer 113 is a sheath. The cable layer 113 comprises a longitudinal weld line 110 which is an artefact of the manufacturing process where two ends of a metal sheath layer are bonded together using a weld. In this example, the weld line 110 comprises a first portion 112 and a second portion 114. Both the first and second portions 112, 114 present as upstanding ribs on the surface of the cable layer 113. The first portion 112 is wider that the second portion 114. The first portion 112 has a lower height than the second portion 114. In other words, the second portion 114 protrudes further from the surface of the cable layer 113 than the first portion 112.

Figure 11 is a 2-D representation 120 of the surface features of the cable layer 113. This representation 120 is formed in the same way as described previously. In particular, a scanner arrangement 24 scans the cable layer 113 in-line with a manufacturing line for manufacturing cable layer 113. This scan data forms a point cloud. A surface fitting algorithm is used to fit a primary surface to the point cloud of the scan data. A point cloud of the primary surface is formed. The point cloud of the primary surface is then removed from the point cloud of the scan data to extract surface texture data. The representation in Figure 11 is greyscale with darker regions representing a greater distance from scanner to surface and lighter regions representing a smaller distance from scanner to surface. In other words, Figure 11 is 2-D topological map of the surface texture of the cable layer 113.

The representation 120 of Figure 11 reflects surface features of the cable layer 113. In particular, a first region 122 of the representation 120 corresponds to the first portion of the weld line 110 and a second region 124 of the representation 120 corresponds to the second portion of the weld line 110.

In one example, the processor 42 is arranged to identify the weld line 110 as a feature of interest. This comprises the processor 42 first determining the height and / or width of the first and / or second region 122, 124 in the representation 120. The processor then compares the height and / or width to one or more threshold criteria. The threshold criteria in this case may be a maximum feature size. In this example, the first and / or second region 122, 124 have a height and or width exceeding the threshold criteria. Therefore, the threshold criteria is not satisfied. Based on this, the processor 42 may be arranged to identify the weld line as a feature of interest and record the scan data associated with the weld line in the memory or storage device 43. It can be particularly advantageous to store the presence and location of a weld line for future reference. This information may be useful in maintenance, for example.

In another example, the processor 43 is arranged to identify defaults or deviations in the weld line 110. In this example, the threshold criteria may correspond to an acceptable range of height and / or width for the weld line 110. If the height and / or width of a portion of the weld line falls outside of this range, then said portion of the weld line may be determined to have a defect or deviation associated therewith. In this example, the first portion 112 of the weld line may have an acceptable height and width but the second portion 114 may have an unacceptable height and / or an unacceptable width. Thus, the processor 43 will determine a defect or deviation for the second portion 114. Again, this may cause the scan data associated with the second portion 114 of the weld line 110 to be recorded in the memory or storage device. This can be useful for later maintenance. Similarly, this information may be used to control the welding on the manufacturing line to compensate or adjust for said defect or deviation (e.g. to increase width and / or reduce height of the weld line).

The process of determining a default or deviation in the weld line may be performed after the step of identifying the weld line as a feature of interest in some examples.

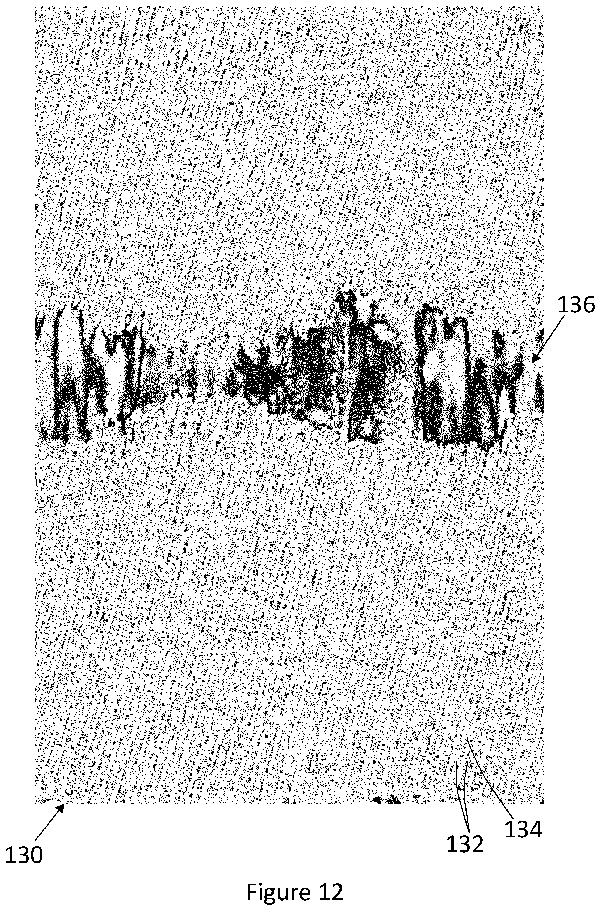

Figure 12 is a 2-D representation 130 of the surface features of another cable layer. The cable layer of this example is a stranded conductor core. The stranded conductor core layer comprises one or more helically stranded conductor strands. Adjacent windings 132 of the conductor are shown in Figure 12. There is a small gap 134 between the adjacent windings 132. In examples, the processor 43 is arranged to determine the height and / or width of each winding 132 and / or the width of the gaps 134 between adjacent windings 132, and / or the pitch or lay length of each winding 132. The processor 43 is then arranged to determine a defect or deviation if one or more of these properties is deemed to be unacceptable. The example of Figure 12 also includes a weld or defect 136. In examples, the processor 43 may further be arranged to determine the weld or defect 136 as a feature of interest. This may be achieved by detecting discontinuities in the determined properties for example.

Several examples of analyzing different cable layers have been described above. However, it should be clear that the method / scanning arrangement could be applied to any intermediate cable layer as part of an in-line surface analysis system.

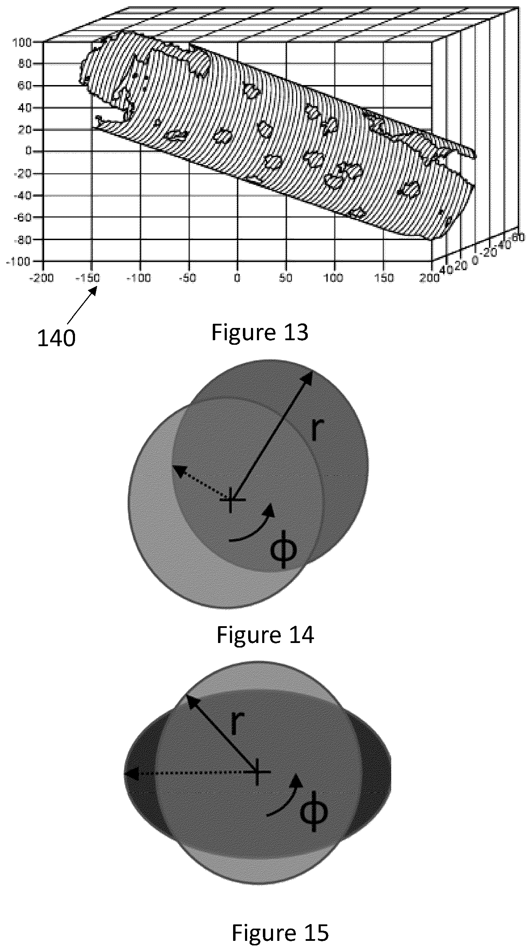

In some examples, the system further comprises a digital twin monitoring unit which receives the scan data recorded in the storage device 43 and performs digital twin modelling of the cable based on the scan data. The digital twin monitoring unit then can provide a report of the monitoring. Figure 13 illustrates an example of a digital twin 130.

As described above, surface texture data is extracted from scan data. In the example above, this extracting comprised fitting a surface to the scan data and subtracting that from the scan data to arrive at the surface texture data. In other examples, it may additionally be necessary to remove off-centering of the cable layer with respect to the scanner arrangement and / or to remove ovality of the cable layer.

Figure 14 represents off-centering. Figure 15 represents ovality.

To assess the centering of the cable end, using cylindrical datapoints, a least squares estimate can be used to fit of the following equation to the data:

$$r_{center}(z,\varphi) = R1_0(z)\sin(\varphi + \alpha1_0(z)) \quad \text{(Equation 1)}$$

$R1_0(z)$ and $\alpha1_0(z)$ (with units m and radians respectively) now are continuous equations, including a parameter set fitted via least squares estimates. $\varphi$ is an angle around a central axis of the cable / cable layer. r represents the distance from the center of the cable. These parameters are represented in Figure 14. These functions describe radial and angular shift partly caused by misalignment between the cylindrical data's original central axis (assigned during 3D scanning) and its true central axis. The radial and angular shift's z-dependencies are important as these also allow for a digital cable "straightening" process in 3D.

To assess ovality, the following equation can be used:

$$r_{ovality}(z,\varphi) = R2_0(z)\sin(2\varphi + \alpha2_0(z)) \quad \text{(Equation 2)}$$

Again, $R2_0(z)$ and $\alpha2_0(z)$ are continuous equations set up to quantify the ovality, the amplitude and angular offset of which may vary with cable length z.

When both ovality and centring need to be removed, in addition to macro-geometric features, in order to obtain textural features, the equation for achieving this is as follows:

$$r_{\text{texture}} = \left(\left(r_{\text{original}} - r_{\text{center}}\right) - r_{\text{ovality}}\right) - r_{\text{macro}} \quad \text{(Equation 3)}$$

This stepwise computational approach allows dividing data into local radial quantities of off-centring, ovality, macro-geometric deviation and texture.

For the sake of completeness, $r_{\text{macro}}$ is the primary surface as described above. In this example, $r_{\text{macro}}$ is determined by fitting a surface to the centred data.

## Claims

1. A system for surface analysis of a cable layer (103) of a cable for power transmission, the system comprising:

   an in-line surface scanner arrangement (24) for scanning a cable layer (103) in or received from a cable manufacturing line (26), the scanner arrangement comprising one or more non-contact distance scanners (32) arranged to measure distance to an outer surface of the received cable layer (103) thereby providing scan data; and
   a controller (43) arranged to:

   receive the scan data of the outer surface of the received cable layer (103) based on signals received from the in-line surface scanner arrangement (24);
   extract surface texture data from the scan data;
   determine one or more properties of the surface of the cable layer based on the surface texture data;
   compare at least one determined property with one or more threshold criteria; and
   identify at least one of a surface feature of interest, a deviation, or a defect based on the comparison.

2. The system of claim 1, wherein extracting surface texture data comprises processing the scan data by subtracting a primary surface from the scan data, wherein the primary surface is representative of the macro-geometric features of the cable layer.

3. The system of claim 2, wherein the controller (43) is arranged to fit a surface to at least some of the scan data using a surface fitting algorithm, the fitted surface being the primary surface.

4. The system of any one of claims 1 to 3, wherein the outer surface of the cable layer (103) comprises a plurality of individual strands, such as a plurality of individual wires, and wherein the one or more properties that the controller is arranged to determine, based on the surface texture data, comprise:

   at least one property of one or more of the individual wire strands such as a strand width; and / or
   at least one property of inter-strand gaps between adjacent strands such as a gap width or a gap depth.

5. The system of any one of claims 1 to 3, wherein the one or more properties that the controller is arranged to determine, based on the surface texture data, comprise:

   at least one property of a weld line (110); and / or
   a pitch of the cable layer.

6. The system of any one of the preceding claims, comprising a non-transitory memory (44), wherein the controller (43) is arranged to store scan data associated with a determined deviation or defect in response to detection of a feature of interest.

7. The system of any one of the preceding claims, further comprising a digital twin monitoring unit, wherein the digital twin monitoring unit is arranged to perform digital twin modelling of the cable layer based on at least some of the scan data and / or surface texture data to create a representation of the cable or cable layer.

8. The system of any one of the preceding claims, wherein the system comprises one or more indicators, such as one or more visual or audible indictors, wherein the controller is arranged to control said one or more indicators to transmit an alert signal if a defect is detected; and/ or

> wherein the in-line scanner arrangement (24) is arranged such that the cable layer (103) is receivable and guidable therethrough in a lengthwise manner; and / or
> wherein the one or more non-contact distance scanners (32) are arranged such that a scanning area extends substantially around a circumference of the received cable layer.

9. The system of any one of the preceding claims, wherein the cable layer (103) is the outermost layer of a partially manufactured cable.

10. The system of any one of the preceding claims, wherein the controller is arranged to determine an ovality of the cable layer and / or an off-centring of the cable layer with respect to the surface scanner arrangement; and wherein the controller (43) is arranged to process the scan data to compensate for said ovality and / or off-centring.

11. The system of any one of the preceding claims, wherein the system further comprises a cable manufacturing line (26) for fabricating the cable layer, optionally wherein the cable manufacturing line (26) is one of a conductor stranding line, a tape lapping line, a metal screen welding line, a cabling line, an armouring line, and a lay-up line.

12. The system of claim 10 or 11, wherein the controller (43) is arranged to control the manufacturing line (26), and wherein, if the controller (43) determines a defect in the cable, the controller is arranged to adjust a parameter of the manufacturing line (103) in response to the detected defect.

13. A computer-implemented method of surface analysis of a cable layer (103) of a cable for cable transmission, the method comprising the steps of:

> receiving scan data from an in-line surface scanner arrangement (24) comprising one or more non-contact distance scanners (32) for measuring an outer surface of the cable layer, wherein the cable layer has been fabricated by a cable manufacturing line;
> extracting surface texture data from the scan data;
> determining one or more properties of the surface of the cable layer based on the surface texture data;
> comparing at least one determined property with one or more threshold criteria; and
> identifying at least one of a surface feature of interest, a deviation, or a defect based on the comparison.

14. A computer program product comprising instructions which, when the program is executed by a computer, cause the computer to carry out the steps of the method of claim 13.

15. A computer-readable storage medium comprising instructions which, when executed by a computer, cause the computer to carry out the steps of the method of claim 13.

Figure 1A

Figure 1B

Figure 2

Figure 3

Figure 4

50

52

54

56

60

62

Yes

No

64

66

Figure 5

70

Figure 6

80

Figure 7

90

Figure 8

102    104   102 104  102  104

103

Figure 9

113    112    110          114

Figure 10

120    122    Figure 11    124

Figure 12

140

Figure 13

Figure 14

Figure 15

| | Europäisches Patentamt European Patent Office Office européen des brevets | **EUROPEAN SEARCH REPORT** | **Application Number** EP 25 17 4403 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/041375 A1 (HARJUHAHTO JANNE [FI] ET AL) 11 February 2021 (2021-02-11) * paragraph [0016] - paragraph [0027]; claim 10; figures 1-4 * ----- | 1-15 | INV. G01B11/245 G01B11/25 G01B11/30 |
| A | CN 114 964 047 B (CHANG LAN ELECTRIC TECHNOLOGY CO LTD) 4 November 2022 (2022-11-04) * figures 1, 2 * ----- | 1-15 | |

**TECHNICAL FIELDS SEARCHED (IPC)**

G01B
G06T
G01N

The present search report has been drawn up for all claims

| Place of search | Date of completion of the search | Examiner |
|---|---|---|
| Munich | 18 August 2025 | Malcoci, Andrei |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 
& : member of the same patent family, corresponding document

## ANNEX TO THE EUROPEAN SEARCH REPORT
## ON EUROPEAN PATENT APPLICATION NO.

EP 25 17 4403

This annex lists the patent family members relating to the patent documents cited in the above-mentioned European search report.
The members are as contained in the European Patent Office EDP file on
The European Patent Office is in no way liable for these particulars which are merely given for the purpose of information.

18-08-2025

| Patent document cited in search report | Publication date | Patent family member(s) | Publication date |
|---|---|---|---|
| US 2021041375 A1 | 11-02-2021 | CN 111837011 A | 27-10-2020 |
| | | EP 3775770 A1 | 17-02-2021 |
| | | FI 20185355 A1 | 14-10-2019 |
| | | PL 3775770 T3 | 19-12-2022 |
| | | RU 2768517 C1 | 24-03-2022 |
| | | TW 201945744 A | 01-12-2019 |
| | | US 2021041375 A1 | 11-02-2021 |
| | | WO 2019197530 A1 | 17-10-2019 |
| CN 114964047 B | 04-11-2022 | NONE | |

EPO FORM P0459

For more details about this annex : see Official Journal of the European Patent Office, No. 12/82